(19) Europäisches Patentamt
European Patent Office
Office européen des brevets

(11) **EP 1 032 125 A1**

(12) **DEMANDE DE BREVET EUROPEEN**

(43) Date de publication:
**30.08.2000 Bulletin 2000/35**

(51) Int. Cl.⁷: **H03H 17/02**

(21) Numéro de dépôt: **00200526.2**

(22) Date de dépôt: **17.02.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **26.02.1999 FR 9902456**

(71) Demandeur:
**Koninklijke Philips Electronics N.V.**
**5621 BA  Eindhoven (NL)**

(72) Inventeurs:
• **Dujardin, Eric**
  **75008 Paris (FR)**
• **Gay-Bellile, Olivier**
  **75008 Paris (FR)**

(74) Mandataire: **Chaffraix, Jean**
  **Société Civile S.P.I.D.**
  **156, Boulevard Haussmann**
  **75008 Paris (FR)**

(54) **Récepteur, circuit programmable et procédé de calcul de filtres numériques**

(57) L'invention présente une méthode de calcul de filtres numériques permettant de multiplexer plusieurs filtres différents à l'aide d'un circuit co-processeur programmable comportant un organe de calcul et des registres à mémoire. Elle consiste à calculer de façon anticipée une partie du résultat de filtre courant avant l'arrivée de la dernière donnée participant au calcul de ce résultat. Pour cela, des produits successifs entre des coefficients de filtre prédéterminés et les données d'entrée correspondantes ayant déjà été utilisées pour le calcul de résultats précédents, sont accumulés de façon itérative dans un résultat intermédiaire, en vue d'anticiper le calcul du résultat courant. Le calcul du dernier résultat intermédiaire pour chaque résultat final est déclenché à la réception de chaque nouvelle donnée d'entrée, de sorte que chaque résultat de filtre est immédiatement disponibles dès la réception de la dernière donnée d'entrée impliquée dans ce résultat.
Application: processeurs multimédia, set top boxes, récepteurs de télévision numérique, etc.

FIG.2

**Description**

L'invention concerne un circuit co-processeur programmable destiné à être associé à un processeur principal pour constituer un filtre numérique à coefficients prédéterminés, circuit comprenant un organe de calcul commandé par un organe de contrôle et recevant des données d'entrée, pour fournir en sortie une suite de résultats de filtre.

Elle concerne également un récepteur de télévision numérique comportant un bloc de démodulation muni d'un dispositif de filtrage.

L'invention concerne enfin un procédé de calcul de filtres pour réaliser des filtres numériques multiplexés à coefficients prédéterminés, à l'aide d'un circuit co-processeur programmable.

Elle a de nombreuses applications notamment dans des systèmes dits 〈〈multimédia〉〉 pour réaliser des filtres numériques en utilisant, par exemple, un processeur de signal, du genre dit DSP, avec des algorithmes spécialisés.

L'article de T.C. Denk et al. Intitulé 〈〈reconfigurable hardware for efficient implementation of programmable FIR filters〉〉 publié dans la revue ICASSP de mai 1998, décrit une architecture de filtre à réponse impulsionnelle finie permettant d'anticiper le calcul d'un résultat de filtre avant l'arrivée de la dernière donnée participant à ce résultat. Pour cela, les données déjà reçues sont mémorisées en vue d'être utilisées dans un calcul intermédiaire anticipé pour le calcul du résultat final courant. Cette méthode implique que la vitesse de calcul du processeur de filtre soit synchronisée avec la vitesse de réception des données.

L'invention décrit un circuit co-processeur permettant plus de souplesse que le circuit connu pour calculer des filtres numériques. En particulier, il permet de multiplexer plusieurs types de filtres différents, le débit d'entrée des données et la vitesse de calcul du processeur n'étant pas liées.

Pour cela, il est prévu un circuit du type mentionné dans le préambule, remarquable en ce que l'organe de calcul comprend un accumulateur destiné à accumuler dans un résultat intermédiaire des produits successifs entre des données d'entrée reçues et les coefficients de filtre, pour réaliser un calcul itératif anticipé du résultat de filtre courant, et en ce que l'organe de contrôle est prévu pour déclencher, à la réception d'une nouvelle donnée, la dernière itération dudit calcul anticipé du résultat courant.

Selon une caractéristique de l'invention, il est prévu un circuit tel que décrit ci-dessus pour constituer un filtre de longueur L, la suite de résultats de filtre, notée [$y_n$], pouvant s'écrire:

$$y_n = \sum_{k=0}^{L-1} \omega_k \times x_{n-k} \qquad (1)$$

où $y_n$ est le résultat du filtre à l'instant n, $\omega_k$ le coefficient prédéterminé d'indice k et $x_{n-k}$, la donnée d'entrée reçue à l'instant n-k, remarquable en ce que, p étant un entier positif égal au nombre de produits susceptibles d'être effectués en parallèle par l'organe de calcul, les itérations dudit calcul anticipé sont effectuées avant l'arrivée de la dernière donnée participant au résultat de filtre $y_n$, chaque itération réalisant le calcul de p produits entre p données d'entrées successives ayant déjà été utilisées pour le calcul du résultat de filtre précédent, noté $y_{n-1}$, et les coefficients de filtre correspondant selon l'équation (1).

Selon une autre caractéristique de l'invention, il est prévu un tel circuit, comportant une pluralité d'organes de contrôle coopérant avec ledit organe de calcul et commandés par un organe de gestion centralisée pour réaliser plusieurs filtres numériques multiplexés, remarquable en ce que ledit organe de gestion comporte une indication de priorité associée à chaque filtre pour déclencher le calcul anticipé d'un résultat de filtre en fonction de la priorité dudit filtre.

Selon un mode de réalisation particulier de l'invention, chaque organe de contrôle réalise un automate à quatre états comprenant:

- un état d'initialisation pour mémoriser les coefficients de chaque filtre,
- un état d'inactivité pour attendre l'arrivée d'une nouvelle donnée d'entrée,
- un état de calcul itératif anticipé destiné à accumuler dans un résultat intermédiaire, à l'aide d'un calcul itératif, des produits entre des données d'entrée successives déjà reçues et les coefficients de filtre correspondants,
- un état de calcul de la dernière itération pour calculer la dernière itération dudit calcul itératif anticipé du résultat courant.

Selon une caractéristique importante de ce mode de réalisation, l'organe de gestion centralisée est prévu pour activer, à la réception de chaque nouvelle donnée d'entrée, l'état de calcul de la dernière itération du filtre auquel ladite nouvelle donnée est destiné.

L'invention prévoit également un procédé de calcul de filtres du genre mentionné dans le préambule comprenant les étapes suivantes:

- une étape d'initialisation pour mémoriser les coefficients de chaque filtre,
- une étape de calcul itératif anticipé destiné à accumuler dans un résultat intermédiaire, à l'aide d'un calcul itératif, des produits entre des données d'entrée successivement reçues et les coefficients de filtre correspondant, pour anticiper le calcul du résultat de filtre courant,
- une étape de calcul de la dernière itération déclenchée à la réception de chaque nouvelle donnée d'entrée pour calculer la dernière itération du calcul itératif anticipé du résultat courant.

La description suivante, faite en regard des dessins ci-annexés, le tout donné à titre d'exemple non limitatif fera bien comprendre comment l'invention peut être réalisée.

La figure 1 représente le diagramme d'état d'un automate pour illustrer un procédé de calcul de filtres selon l'invention.
La figure 2 est un diagramme pour illustrer le fonctionnement de l'organe de gestion centralisée selon l'invention.
La figure 3 représente le schéma bloc d'un circuit co-processeur selon l'invention.
La figure 4 représente un récepteur de télévision numérique selon l'invention.

L'invention s'applique notamment au calcul de filtres numériques à réponse impulsionnelle finie et est très avantageuse dans le cas où plusieurs filtres sont multiplexés à l'aide d'un seul processeur principal. Elle est compatible avec les exigences d'intégration à grande échelle VLSI.

Les algorithmes de démodulation utilisés dans les systèmes de télécommunications numériques, tels que la télévision numérique par câble ou par satellite, requièrent une grande puissance de calcul, d'où est venue l'idée d'utiliser un circuit co-processeur pour soulager le processeur principal des calculs de filtre. Ces circuits spécialisés programmables peuvent être constitués essentiellement d'un processeur de signal numérique ou DSP comprenant entre autres des registres à mémoire pour stocker les coefficients programmables des filtres.

L'invention propose notamment un procédé de calcul de filtres numériques pour multiplexer efficacement plusieurs types de filtres différents. Le problème consiste à résoudre l'équation (1) ci-dessous pour chaque filtre avec un temps de latence minimum.

$$y(n) = \sum_{k=0}^{L-1} \omega_k \times x(n\text{-}k) \tag{1}$$

où y(n) est le résultat du filtre à l'instant n, L la longueur du filtre, $\omega_k$ le coefficient prédéterminé d'indice k et x(n-k), la donnée d'entrée reçue à l'instant n-k.

Le calcul d'un seul résultat de filtre requière ainsi le calcul de L multiplications et une somme de L résultats. La méthode consistant à calculer exactement l'équation (1) implique de mémoriser toutes les données d'entrée jusqu'à l'arrivée de la dernière donnée participant au résultat de filtre courant. L'inconvénient majeur de cette méthode réside dans le temps de latence entre la réception de x(n) et l'émission de y(n) qui est proportionnel à la longueur du filtre.

L'invention propose une autre méthode pour calculer l'équation (1) qui consiste à calculer de façon anticipée une partie du résultat de filtre y(n), avant l'arrivée de la dernière donnée, notée x(n), impliquée dans le calcul de y(n), mais après le calcul du résultat précédent, noté y(n-1). Pour cela, le procédé comprend une étape d'accumulation (appelée également étape itérative de calcul anticipé) pour accumuler dans un résultat intermédiaire des produits successifs entre les coefficients prédéterminés du filtre et les données d'entrée correspondantes selon l'équation (1) ayant déjà été utilisées pour le calcul de résultats de filtre précédents. Chaque résultat intermédiaire, noté y'(n), reçoit de façon itérative, la somme du résultat intermédiaire précédemment calculé et du produit de la donnée disponible la plus récente, soit x(n-k) avec k ∈ {L-1,...,1}, ayant été utilisée pour le calcul du résultat de filtre précédent y(n-1), avec le coefficient de filtre adéquat. Ce qui donne:

$$y'(n) \leftarrow y'(n) + \omega_k \times x(n - k) \qquad \text{avec } k \in \{L\text{-}1,...,1\}$$

où le signe ← indique que le résultat placé à gauche du signe reçoit la valeur placée à droite.

Si le processeur est prévu pour traiter plusieurs données en parallèle sous forme de mots de p données successives, avec p entier supérieur ou égal à 1 et L multiple de p, le calcul du résultat intermédiaire s'écrit alors:

$$y'(n) \leftarrow y'(n) + \sum_{k=i\times p\text{-}1}^{(i\text{-}1)\times p} \omega_k \times x(n - k) \qquad \text{avec } i \in [L/p,...,2\}$$

3

Un calcul itératif anticipé du résultat de filtre courant est ainsi effectué par étapes d'accumulation successives au fur et à mesure de l'arrivée des données, de sorte que lors de l'arrivée de la dernière donnée x(n) impliquée dans le calcul du résultat de filtre y(n), il ne reste plus qu'une dernière étape de calcul pour obtenir le résultat final y(n). Cette dernière étape consiste à calculer le produit de x(n) avec le coefficient prédéterminé correspondant, noté $\omega_0$ selon l'équation (1), et à ajouter ce produit au dernier résultat intermédiaire accumulé. Cette dernière étape appelée étape de dernière itération est réalisable en un cycle d'horloge quelle que soit la longueur du filtre, ce qui améliore considérablement les performances du processeur.

Dans le cas précédemment mentionné où le processeur est prévu pour traiter plusieurs données en parallèle, p étant le nombre de données comprises dans un mot, le calcul de la dernière itération s'écrit alors:

$$y(n) = y'(n) + \sum_{k=0}^{p-1} \omega_k \times x(n - k)$$

Une étape d'initialisation est également prévue pour stocker les coefficients des filtres ainsi que les premières données reçues pour pouvoir démarrer le calcul du premier résultat de filtre.

Selon ce procédé, la vitesse d'entrée des données et la vitesse de calcul du processeur peuvent être indépendantes, ce qui permet également de multiplexer plusieurs filtres différents.

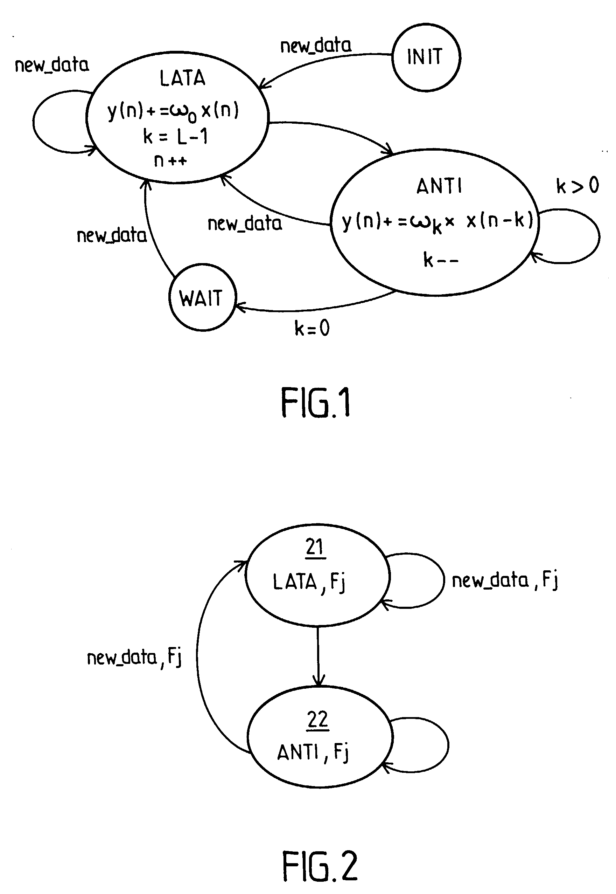

La figure 1 représente le diagramme d'état d'un automate pour réaliser le calcul d'un filtre selon le procédé ci-dessus décrit. Il comporte quatre états notés INIT, WAIT, ANTI et LATA, où:

- INIT est un état d'initialisation pour mémoriser les coefficients du filtre,
- ANTI est un état de calcul itératif anticipé destiné à accumuler dans un résultat intermédiaire, à l'aide d'un calcul itératif, des produits entre des données d'entrée successives déjà reçues et les coefficients de filtre correspondants, ce qui revient à anticiper un calcul partiel du résultat courant à l'aide des données reçues déjà disponibles,
- WAIT est un état d'inactivité dans lequel le processeur se trouve lorsqu'il n'a plus rien à faire en attendant l'arrivée d'une nouvelle donnée d'entrée, par exemple lorsque tous les calculs itératifs anticipés du résultat courant ont été effectués dans l'état ANTI,
- LATA correspond à l'état de calcul de la dernière itération du calcul anticipé du résultat courant, il est déclenché à la réception d'un nouvelle donnée d'entrée.

Le calcul de la dernière itération du résultat intermédiaire en cours est donc synchronisé avec la réception de chaque nouvelle donnée d'entrée. Pour cela, l'automate est prévu pour passer à l'état LATA depuis n'importe lequel des quatre états possibles sur un seul événement particulier: la réception d'une nouvelle donnée d'entrée (new_data). Il reste dans cet état tant qu'il reçoit des données. Ainsi dans l'état LATA, le processeur calcule la dernière itération du calcul du résultat final y(n) pour envoyer ce résultat en sortie du filtre. La nouvelle donnée d'entrée étant notée x(n), le calcul de la dernière itération consiste à calculer le produit $\omega_0 \times x(n)$ puis à l'ajouter au résultat intermédiaire précédemment calculé, noté $y_1'(n)$.

S'il ne reçoit pas de nouvelle donnée d'entrée à partir de l'état LATA, le processeur est automatiquement placé dans l'état ANTI pour anticiper le calcul du résultat de filtre suivant y(n+1) en itérant le calcul du résultat intermédiaire y'(n+1), à l'aide des données déjà disponibles. Pour $i \in \{1,..., L\}$ et k = L-i , la ième itération du résultat intermédiaire destiné au calcul du résultat y(n+1), notée $y_i'(n+1)$, s'écrit:

$$y_i'(n + 1) \leftarrow y_{i-1}'(n + 1) + \omega_k \times x(n - k)$$

$$y'_0(n + 1) = 0$$

où le signe $\leftarrow$ indique que le résultat placé à gauche du signe reçoit la valeur placée à droite. L'indice k est décrémenté après chaque itération du calcul anticipé (k--), tant que k reste strictement positif (k>0). Lorsque k devient nul et si aucune nouvelle donnée n'est reçue, le résultat intermédiaire précédemment calculé étant alors noté $y_{L-1}'(n+1)$, le processeur est automatiquement placé dans l'état WAIT pour attendre la prochaine donnée d'entrée x(n+1) qui permettra de terminer le calcul du résultat y(n+1).

En résumé, quel que soit l'état courant du processeur, il est automatiquement placé dans l'état LATA à la réception d'une nouvelle donnée d'entrée. Entre-temps, une fois la phase d'initialisation INIT achevée, il peut être soit dans l'état ANTI tant que toutes les itérations du calcul anticipé du résultat suivant ne sont pas terminées, soit dans l'état WAIT, lorsque tous les calculs anticipés impliquant des données disponibles, ayant déjà servi aux calculs de résultats de filtre précédents, sont achevés.

**EP 1 032 125 A1**

La figure 2 montre le diagramme d'états d'un organe de gestion centralisée ou encore organiseur pour organiser les calculs entre différents filtres numériques indépendants multiplexés. Chaque filtre est commandé par un organe de contrôle ou automate indépendant, fonctionnant par exemple selon la machine à quatre états décrite ci-dessus en référence à la figure 1. L'organiseur affecte un indice de priorité à chaque filtre pour optimiser l'organisation des calculs.

Selon le mode de réalisation représenté à la figure 2, l'organiseur comporte deux états numérotés 21 et 22. La réception d'une donnée d'entrée destinée à un filtre déterminé, noté Fj, place l'organiseur dans l'état 21, qui déclenche l'état de calcul de la dernière itération LATA pour le filtre considéré. L'événement déclencheur est représenté sur la figure par les flèches portant la menton new_data Fj. Le reste du temps, l'organiseur se trouve dans l'état 22 pour déclencher l'état de calcul anticipé ANTI des différents filtres selon leur degré de priorité.

Pour gérer efficacement ces calculs, l'organiseur et la machine d'état doivent connaître le contexte particulier de chaque filtre, c'est-à-dire le type de données traitées, le type de filtre, la position des pointeurs en lecture et en écriture, etc. L'organiseur interrompt le calcul anticipé d'un filtre, même ci celui-ci n'est pas terminé, pour déclencher le calcul de la dernière itération pour un autre filtre quelle que soit sa priorité si une nouvelle donnée pour cet autre filtre est reçue.

Si aucune nouvelle donnée n'est reçue, l'organiseur déclenche le calcul anticipé du filtre le plus prioritaire en attendant la réception d'une nouvelle donnée d'entrée.

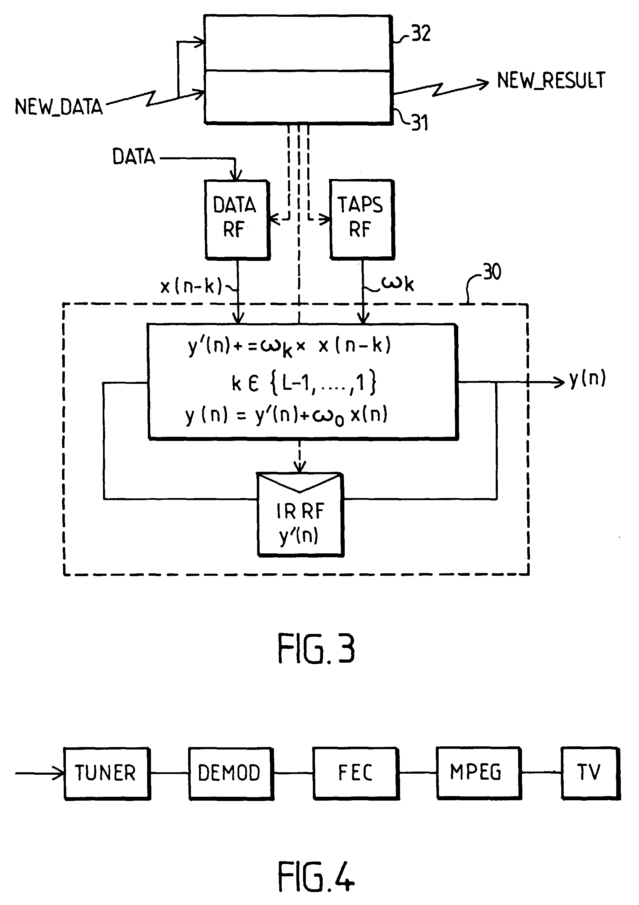

Un processeur de filtre selon l'invention est représenté sous forme de schéma blocs à la figure 3. Il comporte les éléments suivants:

- des registres à mémoire DATA RF et TAPS RF pour stocker respectivement les données d'entrée avant leur utilisation dans les calculs ainsi que les coefficients prédéterminés des différents filtres,
- un organe de calcul 30 muni d'entrées pour recevoir les données et les coefficients stockés dans les registres DATA RF et TAPS RF, constitué essentiellement d'un multiplieur, d'un additionneur et de n registres d'accumulation IR RF pour n filtres multiplexés (pour des raisons de clarté, un seul registre est représenté sur la figure 3), chaque registre d'accumulation étant destiné à accumuler selon un calcul itératif, des produits successifs entre les données d'entrée et les coefficients mémorisés, dans un résultat intermédiaire,
- un organe de contrôle ou machine d'états 31 associé à chaque filtre, pour commander les différents blocs cités ci-dessus,
- un organe de gestion centralisée ou organiseur 32 pour contrôler les machines d'états des différents filtres.

Pendant l'état d'initialisation INIT, les coefficients de chaque filtre sont mémorisés dans le registre TAPS RF tandis que les premières données reçues (leur nombre étant égal à la longueur du filtre, c'est-à-dire au nombre de coefficients) sont mémorisées dans le registre DATA RF. Chaque machine d'état 31 envoie un signal de contrôle aux registres de mémoire DATA RF et TAPS RF pour commander le stockage des données. Au fur et à mesure de leur réception, les données d'entrée DATA, sont ainsi stockées dans le registre DATA RF en vue d'être utilisées par l'organe de calcul 30.

A la réception de chaque nouvelle donnée d'entrée DATA, la machine d'état du filtre destinataire de la donnée reçoit un signal de contrôle, NEW_DATA, pour activer l'état de calcul de la dernière itération LATA. La machine d'état génère alors un signal, NEW_RESULT, pour indiquer qu'un nouveau résultat de filtre y(n) est disponible en sortie et pour réinitialiser le registre d'accumulation IR RF ayant contenu les itérations successives des résultats intermédiaires anticipés au résultat y(n). Dans les états LATA et ANTI, des signaux de contrôle dessinés en traits interrompus sur la figure 3 sont envoyés aux registres DATA RF et TAPS RF pour qu'ils fournissent à l'organe de calcul les données nécessaires aux calculs mis en oeuvre dans ces deux états.

La figure 4 montre, à titre d'exemple de réalisation, un schéma général d'un récepteur de télévision numérique ou set top box destiné à assurer le décodage des trames de données transmises sur un canal de transmission. Il comporte:

- un bloc TUNER comprenant un tuner pour recevoir un signal d'entrée analogique et le convertir dans une fréquence intermédiaire plus basse,
- un bloc de démodulation DEMOD pour numériser le signal analogique reçu et le démoduler afin d'assurer la synchronisation des données constituant le signal sous forme de trames de données numériques,
- un bloc de correction d'erreur FEC (de l'anglais Forward Error Correction) pour corriger les erreurs de transmission dues au canal,
- un bloc de décodage de source MPEG utilisant, par exemple, un décodeur selon la norme MPEG pour décoder le message reçu et
- un bloc de visualisation TV comprenant notamment un tube cathodique.

Un filtrage numérique est nécessaire pour assurer la fondion du démodulateur 42. Celui-ci peut être réalisé de façon avantageuse, à l'aide d'un circuit du type de celui représenté à la figure 3.

Ainsi ont été décrits et illustrés à l'aide d'exemples un récepteur, un circuit processeur de filtres et un procédé de calcul de filtres numériques permettant de multiplexer différents types de filtres destinés notamment à recevoir des données ayant des formats et des vitesses d'entrée variés. Bien entendu, de nombreuses variantes pourront être apportées aux modes de réalisation décrits sans sortir du cadre de l'invention.

**Revendications**

1. Circuit co-processeur programmable destiné à être associé à un processeur principal pour constituer un filtre numérique à coefficients prédéterminés, circuit comprenant un organe de calcul commandé par un organe de contrôle et recevant des données d'entrée, pour fournir en sortie une suite de résultats de filtre,

   **caractérisé en ce que** l'organe de calcul comprend un accumulateur destiné à accumuler dans un résultat intermédiaire des produits successifs entre des données d'entrée reçues et les coefficients de filtre, pour réaliser un calcul itératif anticipé du résultat de filtre courant, **et en ce que** l'organe de contrôle est prévu pour déclencher la dernière itération dudit calcul anticipé du résultat courant, à la réception d'une nouvelle donnée.

2. Circuit selon la revendication 1, pour constituer un filtre de longueur L, la suite de résultats de filtre, notée $[y_n]$, pouvant s'écrire:

$$y_n = \sum_{k=0}^{L-1} \omega_k \times x_{n-k} \qquad (1)$$

   où $y_n$ est le résultat du filtre à l'instant n, $\omega_k$ le coefficient prédéterminé d'indice k et $x_{n-k}$, la donnée d'entrée reçue à l'instant n-k, **caractérisé en ce que**, p étant un entier positif égal au nombre de produits susceptibles d'être effectués en parallèle par l'organe de calcul, toutes les itérations dudit calcul anticipé sont effectuées avant l'arrivée de la dernière donnée participant au résultat de filtre $y_n$, chaque itération réalisant la somme de p produits entre p données d'entrées successives ayant déjà été utilisées pour le calcul du résultat de filtre précédent, noté $y_{n-1}$, et les coefficients de filtre correspondant selon l'équation (1).

3. Circuit selon l'une des revendications 1 ou 2, comportant une pluralité d'organes de contrôle coopérant avec ledit organe de calcul, commandés par un organe de gestion centralisée pour réaliser plusieurs filtres numériques multiplexés, **caractérisé en ce que** ledit organe de gestion comporte une indication de priorité associée à chaque filtre pour déclencher le calcul anticipé d'un résultat de filtre en fonction de la priorité dudit filtre.

4. Circuit selon la revendication 3, caractérisé en ce que chaque organe de contrôle réalise un automate à quatre états comprenant:

   • un état d'initialisation pour mémoriser les coefficients de chaque filtre,
   • un état d'inactivité pour attendre l'arrivée d'une nouvelle donnée d'entrée,
   • un état de calcul itératif anticipé destiné à accumuler dans ledit résultat intermédiaire, à l'aide d'un calcul itératif, des produits entre des données d'entrée successives déjà reçues et les coefficients de filtre correspondants,
   • un état de calcul de la dernière itération pour calculer la dernière itération dudit calcul itératif anticipé du résultat courant.

5. Circuit selon la revendication 4, caractérisé en ce que ledit organe de gestion centralisée est prévu pour activer, à la réception de chaque nouvelle donnée d'entrée, l'état de calcul de la dernière itération correspondant au filtre auquel ladite nouvelle donnée est destinée.

6. Récepteur de télévision numérique destiné à recevoir des données d'entrée numériques, comportant un bloc de démodulation muni d'un dispositif de filtrage, caractérisé en ce que ledit dispositif de filtrage comporte un circuit selon l'une des revendications 1 à 5 pour filtrer les données reçues.

7. Procédé de calcul pour réaliser des filtres numériques multiplexés à coefficients prédéterminés, à l'aide d'un circuit co-processeur programmable destiné à recevoir des données d'entrée et à fournir en sortie une suite de résultats de filtre, **caractérisé on ce qu'il** comprend les étapes suivantes:

- une étape d'initialisation pour mémoriser les coefficients de chaque filtre,
- une étape itérative de calcul anticipé destinée à accumuler dans un résultat Intermédiaire, à l'aide d'un calcul itératif, des produits entre des données d'entrée successivement reçues et les coefficients de filtre correspondant, pour anticiper le calcul du résultat de filtre courant.
- une étape de calcul de la dernière itération déclenchée à la réception de chaque nouvelle donnée d'entrée pour calculer la dernière itération du calcul anticipé du résultat courant.

FIG.1

FIG.2

NEW_DATA

32

NEW_RESULT

31

DATA

DATA
RF

TAPS
RF

$x(n-k)$

$\omega k$

30

$$y'(n)+=\omega_k \times x(n-k)$$

$$k \in \{L-1, \ldots, 1\}$$

$$y(n) = y'(n)+\omega_0 x(n)$$

$y(n)$

IR RF
$y'(n)$

## FIG. 3

| TUNER | DEMOD | FEC | MPEG | TV |
|-------|-------|-----|------|-----|

## FIG. 4

**Office européen des brevets**

# RAPPORT DE RECHERCHE EUROPEENNE

Numéro de la demande

EP 00 20 0526

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| D,A | DENK T C ET AL: "Reconfigurable hardware for efficient implementation of programmable FIR filters" PROCEEDINGS OF THE 1998 IEEE INTERNATIONAL CONFERENCE ON ACOUSTICS, SPEECH AND SIGNAL PROCESSING, ICASSP '98 (CAT. NO.98CH36181), PROCEEDINGS OF THE 1998 IEEE INTERNATIONAL CONFERENCE ON ACOUSTICS, SPEECH AND SIGNAL PROCESSING, SEATTLE, WA, USA, 12-1, pages 3005-3008 vol.5, XP002121976 1998, New York, NY, USA, IEEE, USA ISBN: 0-7803-4428-6 * alinéas [0002],[0004]; figure 1 * | 1-7 | H03H17/02 |
| A | US 5 904 731 A (MATSUI SATOSHI) 18 mai 1999 (1999-05-18) * colonne 5, ligne 1 - ligne 50; figure 4 * & JP 08 044703 A (FUJITSU LTD.) 16 février 1996 (1996-02-16) | 1,7 | |
| A | EP 0 445 335 A (ITT IND GMBH DEUTSCHE) 11 septembre 1991 (1991-09-11) * abrégé; figure 1 * | 3 | DOMAINES TECHNIQUES RECHERCHES (Int.Cl.7) H03H G06F |
| A | EP 0 046 121 A (MATRA) 17 février 1982 (1982-02-17) * page 3, ligne 25 - page 5, ligne 2 * | 1 | |

Le présent rapport a été établi pour toutes les revendications

| Lieu de la recherche | Date d'achèvement de la recherche | Examinateur |
|---|---|---|
| LA HAYE | 8 juin 2000 | D/L PINTA BALLE.., L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 00 20 0526

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-06-2000

| Document brevet cité au rapport de recherche | Date de publication | Membre(s) de la famille de brevet(s) | Date de publication |
|---|---|---|---|
| US 5904731 A | 18-05-1999 | JP 8044703 A | 16-02-1996 |
| EP 0445335 A | 11-09-1991 | AUCUN | |
| EP 0046121 A | 17-02-1982 | FR 2488756 A | 19-02-1982 |

EPO FORM P0460

Pour tout renseignement concernant cette annexe : voir Journal Officiel de l'Office européen des brevets, No.12/82